# EUROPÄISCHE PATENTSCHRIFT

(11) **EP 1 329 145 B1**
(45) Veröffentlichungstag und Bekanntmachung des Hinweises auf die Patenterteilung: **17.08.2005**
(21) Anmeldenummer: 01989042.5
(22) Anmeldetag: 17.10.2001
(51) Int. Cl.: H05K 7/20

(54) **FLÜSSIGKEITSGEKÜHLTES GEHÄUSE**
LIQUID-COOLED HOUSING
BOITIER REFROIDI PAR UN LIQUIDE

(30) Priorität: 24.10.2000 DE 10052712
(43) Veröffentlichungstag der Anmeldung: 23.07.2003
(73) Patentinhaber: Siemens Aktiengesellschaft, 80333 München (DE)
(72) Erfinder: EICHENSEHER, Volker, 93176 Beratzhausen (DE)
(86) Internationale Anmeldenummer: PCT/DE2001/003961
(87) Internationale Veröffentlichungsnummer: WO 2002/035898

(56) Entgegenhaltungen:
- EP-A- 0 309 986
- DE-A- 4 427 947
- DE-C- 19 813 532
- FR-A- 2 624 684
- GB-A- 2 249 875
- US-A- 3 865 183
- US-A- 6 031 751

## Beschreibung

Die Erfindung betrifft ein flüssigkeitsgekühltes Gehäuse, insbesondere zur Aufnahme von elektrischen und/oder elektronischen Komponenten und/oder Schaltungen gemäß den Merkmalen des unabhängigen Anspruches.

Viele Steuergeräte und elektrische Komponenten entwickeln im Betrieb erhebliche Wärme, die abgeführt werden muss. So ist beispielsweise die Wärmeentwicklung eines LeistungsUmrichters im Kraftfahrzeug, wie er zur Ansteuerung eines integrierten Starter-Generators erforderlich ist, so erheblich, dass eine aktive Kühlung fast unumgänglich ist. Hinzu kommt die notwendige kompakte Bauweise sowie der typische Einbauort im Motorraum des Kraftfahrzeuges, was die Temperaturbelastung zusätzlich erhöht. Zur aktiven Kühlung kommen bspw. eine Luftkühlung mittels Gebläse, eine Flüssigkeits- oder Wasserkühlung oder auch eine Siedebadkühlung in Frage. Zur Realisierung einer Wasserkühlung werden typischerweise Platten- oder Flächenkühler eingesetzt, die dann mittels Hilfsplatten oder -profilen thermisch mit den elektrischen Leistungsbauelementen gekoppelt werden. Eine solche Bauweise bringt allerdings keinen optimalen Wirkungsgrad. Zudem wird dadurch die elektrische Anbindung eines Zwischenkreises erheblich gestört, da dieser räumlich aufgeteilt werden muss und nicht mehr optimal kurze Leitungswege zwischen den Bauteilen möglich sind.

Aus der Patentanmeldung EP 0 309 986 A1 ist ein Steuergerät für den Einsatz in einem Kraftfahrzeug bekannt, dessen eine Seite in Kontakt mit Kühlwasser einer Brennkraftmaschine steht. In der Praxis ist es allerdings schwierig, die absolute Dichtigkeit eines solches Steuergeräts sicherzustellen. Ein weiteres Problem eines derartigen Steuergerätes liegt darin, dass eine Reparatur oder ein Austausch des an den Kühlwasserkreislauf angeschlossenen Steuergerätes nur erschwert möglich ist.

Weiterhin ist aus der Patentschrift DE 198 13 532 C1 ein Steuergerät mit Flüssigkeitskühlung bekannt, bei dem an einer Außenwand des Steuergeräts ein relativ großflächiger, von einer Flüssigkeit durchströmter Kühler angebracht ist. Die mechanische und thermische Koppelung zwischen Kühler und Steuergerät erfolgt mittels einer elastischen und wärmeleitenden Kontaktplatte. Nachteilig an dieser Anordnung ist der zusätzliche Bauaufwand für die nachträgliche Anbringung des Kühlers am Steuergerät sowie die ungleichmäßige Kühlwirkung für die Komponenten im Steuergerät, die an der Kontaktstelle des Kühlers am größten ist, jedoch an der Gehäuserückseite deutlich geringer ausfällt.

Aus der Patentanmeldung GB 2 249 875 A ist eine Anordnung für gedruckte Leiterplatten bekannt, die ein Gehäuse aufweist, in dessen Schienen gehäuste bedruckte Leiterplatten eingeschoben werden können und im eingebauten Zustand über ihre Seitenflächen Wärme an das Gehäuse, dass von einer Flüssigkeit gekühlt wird, abgeben.

Aus der Patentschrift US 6,031,751 ist ein Kühlkörper für eine elektronische Schaltung bekannt, der sich durch ein kleines Volumen auszeichnet.

Es ist ein Ziel der Erfindung, eine Vorrichtung zur Kühlung eines Steuergerätes oder anderer elektrischer Komponenten und/oder Schaltungen bereitzustellen, die einen kompakten Aufbau und gleichzeitig eine möglichst effektive Abführung von Wärmeverlustleistung der Komponenten und/oder der Schaltungen ermöglicht.

Dieses Ziel der Erfindung wird mit einem Gehäuse erreicht, wie es im unabhängigen Anspruch definiert ist. Mit dem erfindungsgemäßen flüssigkeitsgekühlten Gehäuse können die darin befindlichen elektrischen Leistungsbauelemente optimal gekühlt werden. Zudem können diese auf kleinstem Raum ideal symmetrisch angeordnet werden, so dass die elektrischen Verbindungsleitungen zwischen den Bauteilen sehr kurz ausgeführt sein können. Beispielsweise ist bei einem Leistungsumrichter mit Zwischenkreis ein kompakter, symmetrischer Aufbau entscheidend, um die Verlustleistungen aufgrund der Leitungswiderstände gering zu halten.

Durch integral im Gehäuse verlaufende Kühlkanäle bildet das Gehäuse selbst den Kühler, an dessen inneren Seitenflächen die Bauteile montiert werden können. Mit einem in der Mitte platzierten Zwischenkreis aus Kondensatoren und den an den Gehäusewänden thermisch leitend montierten Halbleiter-Schaltelementen (bspw. Transistoren) ist ein symmetrischer Aufbau und damit eine möglichst ideale elektrische Verbindung zwischen den Bauteilen ermöglicht.

Weitere vorteilhafte Ausbildungen der Erfindung sind in den abhängigen Ansprüchen gekennzeichnet.

Nachfolgend wird die Erfindung anhand von bevorzugten Ausführungsbeispielen unter Bezugnahme auf die Zeichnung näher erläutert. Es zeigen:
- Figur 1a: ein erfindungsgemäßes Gehäuse in zusammengebautem Zustand,
- Figur 1b: eine Teilansicht auf einen Ausbruch des erfindungsgemäßen Gehäuses,
- Figur 2: eine Explosionszeichnung des Gehäuses entsprechend Figur 1 sowie der darin enthaltenen Komponenten und
- Figur 3: eine Gestaltungsvariante des erfindungsgemäßen Gehäuses.

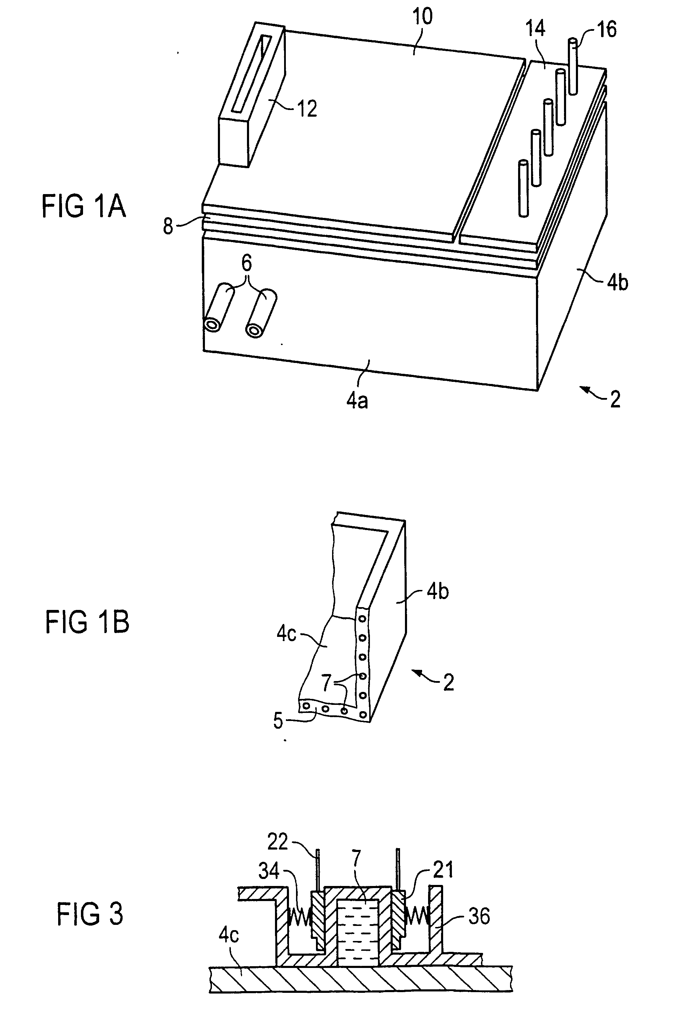

Die Figur 1a zeigt ein erfindungsgemäßes Gehäuse 2 in zusammengebautem Zustand. Das Gehäuse 2 ist im dargestellten Ausführungsbeispiel im wesentlichen quaderförmig ausgeführt und weist spitze Ecken und Kanten auf. Ebenso möglich sind jedoch fast beliebig andere Gehäuseformen sowie schräge oder abgerundete Ecken und Kanten. An einer Frontseite 4a des Gehäuses sind zwei senkrecht aus dieser Wand heraus ragende Anschlussstutzen erkennbar, die eine Zu- bzw. Ableitung für im Gehäuse 2 zirkulierende Kühlflüssigkeit bilden. Die obere Seite des Gehäuses 2 ist mit einem flachen Deckel 8 verschlossen, der ggf. weitere Funktionen aufweisen kann. Bspw. kann der Deckel 8 eine elektrische Leiterplatte tragen oder selbst als Leiterplatte ausgebildet sein. Auf dem Deckel 8 befindet sich eine Steckerleiste 14, aus der mehrere elektrische Anschlüsse ragen, die im dargestellten Ausführungsbeispiel als Leistungsanschlüsse 16 zur Beaufschlagung mit starken elektrischen Strömen vorgesehen sind. Erkennbar ist weiterhin eine den Deckel 8 bedeckende weitere Platte, bspw. eine Steuerschaltung 10 oder dgl., die über einen aus dieser Steuerschaltung 10 nach oben herausgeführten Verbindungsstecker 12 mit einer Steuerschaltung oder dgl. verbunden werden kann.

Figur 1b zeigt einen herausgebrochenen Eckausschnitt des leeren Gehäuses 2 entsprechend Figur la. Erkennbar ist ein Teil einer Seitenfläche 4b, ein Teil einer rechtwinkelig auf diese stoßenden Rückseite sowie ein Teil einer rechtwinkelig auf die genannten Flächen stoßenden Bodenfläche 4c des Gehäuses 2. Wie anhand des in dieser Ansicht sichtbar gemachten Wandquerschnittes 5 erkennbar ist, sind im Gehäuse 2 eine Vielzahl von Kühlkanälen geführt, die integraler Bestandteil der Gehäusewände 4a, 4b, 4c sind. Im dargestellten Ausführungsbeispiel sind die Kühlkanäle 7 jeweils im wesentlichen parallel zueinander sowie parallel zu den Gehäusekanten geführt, wobei die Kühlkanäle 7 in den seitlichen Gehäusewänden 4a, 4b jeweils parallel zu den jeweiligen Längskanten dieser Wände verlaufen. Ebenso möglich und vorteilhaft sind jedoch auch andere Verläufe der Kühlkanäle, bspw. wenn diese meanderförmige oder schräg verlaufen.

Um einen möglichst guten und gleichmäßigen Wärmeübergang von den Gehäuseinnenseiten bzw. -wänden zur in den Kühlkanälen 7 zirkulierenden Kühlflüssigkeit zu erreichen, kann es vorteilhaft sein, wenn der Abstand zweier Kühlkanäle 7 zueinander nicht wesentlich größer ist als der doppelte Abstand eines Kühlkanals von der Innenwand des Gehäuses 2. Wenn bspw. die Wandstärke d des Gehäuses einen Wert von 10 mm aufweist, so könnte ein bevorzugter Durchmesser für die Kühlkanäle bei einem Wert von 6 mm (3/5 d) liegen. Ein sinnvoller Abstand zweier Kühlkanäle zueinander läge dann bei einem Wert von ca. 4 mm (2/5 d). Dies sind allerdings nur beispielhafte Werte, die je nach Anwendungsfall auch erheblich modifiziert sein können.

Als Material für das Gehäuse 2 eignet sich insbesondere Metall, bspw. Aluminium, Magnesium oder entsprechende Legierungen. Aluminium weist eine besonders hohe Wärmeleitfähigkeit auf und ermöglicht daher einen guten Wärmeübergang von den Gehäusewänden zu der zirkulierenden Kühlflüssigkeit. Ein solches Aluminium- oder Magnesiumgehäuse lässt sich auf einfachem Weg mittels Druck- oder Feingussverfahren herstellen, wobei sich die Kühlkanäle über sog. verlorene Kerne auf einfache Weise einbringen lassen.

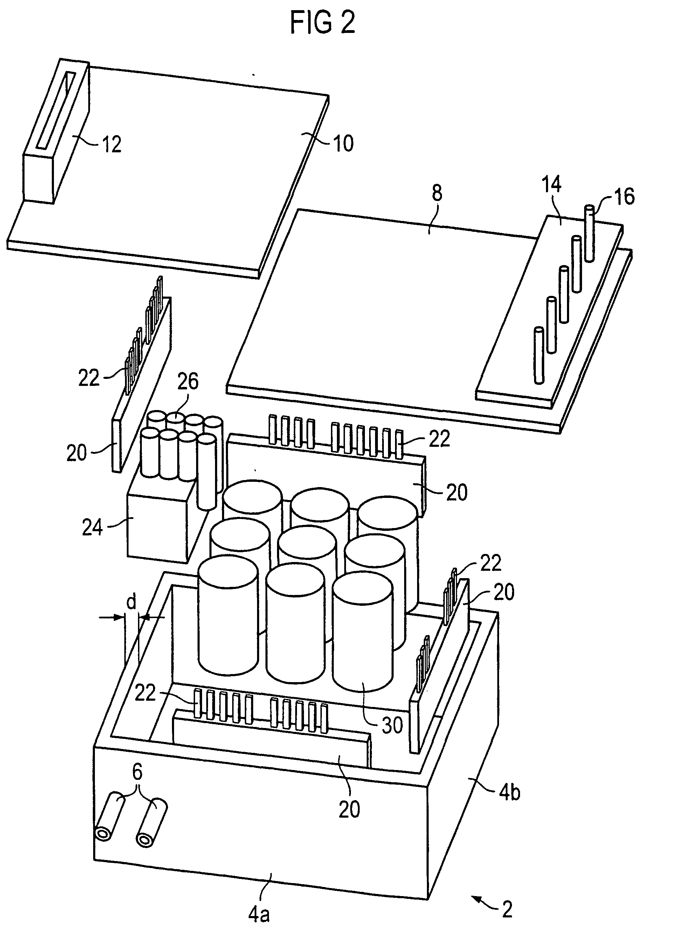

Weiterhin ist in Figur 2 das Gehäuse 2 entsprechend Figur 1 sowie darin enthaltene Komponenten in einer Explosionszeichnung dargestellt. Erkennbar ist wiederum das im wesentlichen quaderförmige Gehäuse 2 mit zwei aus der Frontseite 4a ragenden Anschlussstutzen 6 zur Zu- und Abfuhr von Kühlflüssigkeit. An den inneren Gehäusewänden sind im zusammengebauten Zustand mehrere - jeweils mit dem Bezugszeichen 20 versehene - längliche rechteckige Scheiben angebracht, die jeweils mit nach oben weisenden Anschlusssteckern 22 zur elektrischen Verbindung versehen sind. Diese Scheiben können bspw. als sogenannte DCB(Direct Copper Bounding)-Elemente 20 ausgestaltet sein, worunter im folgenden ein Zusammenbau aus einem Keramikträger mit direkt darauf aufgebrachten Kupferleitungen sowie einem oder mehreren direkt mit den Kupferleitungen über sog. Bonding-Verbindungen elektrisch leitend verbundenem Halbleiterbauelement zu verstehen ist. Das Halbleiterbauelement kann im einfachsten Fall ein Transistor oder Thyristor, ebenso jedoch auch ein komplexer integrierter Schaltkreis sein. Die auf dem Keramikträger aufgebrachten flachen Kupferleitungsbahnen sind bspw. durch Spritzen aufgebracht. Die Trägerscheibe besteht aus einem Keramikmaterial, das als Isolator wirkt und über eine möglichst gute Wärmeleitfähigkeit verfügt.

Im vorliegenden Ausführungsbeispiel bilden die im Gehäuse 2 befindlichen Schaltungskomponenten eine Leistungsumrichterschaltung mit mehreren Kondensatoren 30 hoher Kapazität, die als Energiezwischenspeicher fungieren. Ein derartiger Leistungsumrichter wird bspw. in Kraftfahrzeugen benötigt, die über einen integrierten Starter-Generator anstatt herkömmlicher Lichtmaschine und elektrischem Anlasser verfügen. Ein solcher integrierter Starter-Generator ist typischerweise als Asynchronmaschine ausgeführt, die mit einer Nennspannung von 42 Volt betrieben wird und im Generatorbetrieb auch eine solche Nennspannung liefert. Zum Start einer Brennkraftmaschine im Kraftfahrzeug mittels dieses Starter-Generators kann es erforderlich sein, eine verfügbare Gleichspannung von 12 Volt, wie sie ein herkömmlicher Akkumulator liefern kann, in eine 42-Volt-Gleich- oder Wechselspannung zu wandeln. Sowohl bei dieser Wandlung als auch der Wandlung einer vom Starter-Generator im Generatorbetrieb gelieferten 42-Volt-Wechselspannung in eine 12-Volt-Gleichspannung zur Versorgung des elektrischen Bordnetzes des Fahrzeugs fließen sehr hohe Ströme durch den Leistungsumrichter.

Die in den DCB-Elementen 20 enthaltenen Leistungstransistoren entwickeln dabei eine sehr hohe Verlustleistung, die in Form von Wärme entsteht und im geschlossenen Gehäuse kaum abgeführt werden kann. Eine herkömmliche Kühlung mittels passiver Kühlkörper oder Kühlgebläse, bei denen die Umgebungsluft den Wärmeabtransport bewältigen muss, ist entweder nicht leistungsfähig genug oder benötigt große Kühlflächen und damit einen relativ großen Bauraum. Aus diesem Grund sind die DCB-Elemente 20 direkt mit ihren flachen Seiten an die vier Innenseiten des Gehäuses 2 aufgebracht, bspw. mittels Verklebung oder über Federklemmverbindungen. Die Wärmeableitung kann dann über die in den Kühlkanälen 7 des Gehäuses 2 zirkulierende Kühlflüssigkeit abgeführt werden, wobei bei größerer Wärmeentwicklung eine schnellere Zirkulation vorgesehen sein kann.

Erkennbar in Figur 2 sind weiterhin eine Gruppe von neun zylindrischen Kondensatoren 30, die in jeweils drei Dreierreihen mit aneinander grenzenden Mantelflächen in der Mitte des Gehäuses 2 platziert sind. Diese Kondensatoren 30 bilden zusammen einen sog. Zwischenkreis und dienen im wesentlichen zur Energiepufferung, um beim Start der Brennkraftmaschine eine möglichst große elektrische Leistung zur Verfügung zu haben. Über den Berührungskontakt der unteren Stirnflächen der Kondensatoren zum Gehäuseboden, der vorzugsweise ebenfalls über Kühlkanäle 7 verfügt, kann auch in den Kondensatoren entstehende Wärmeverlustleistung abgeführt werden. Dieser Berührungskontakt kann bspw. auch über ein hier nicht dargestelltes Zwischenblech hergestellt sein. Die symmetrische Gruppierung der Kondensatoren 30 und der annähernd symmetrisch um diese gruppierten Leistungstransistoren in den DCB-Elementen 20 sorgt aufgrund der sehr kurzen elektrischen Verbindungsleitungen für eine niederohmige elektrische Verbindung und sowie für eine weitgehend gleichmäßige Belastung für die Kondensatoren 30 des Zwischenkreises sowie für die Leistungstransistoren, was für alle genannten Bauteile - neben der Kühlung - eine weitere Erhöhung der Bauteillebensdauer nach sich zieht.

Erkennbar sind weiterhin zwei Gleichrichter 24 mit jeweils nach oben herausgeführten Gleichrichteranschlüssen 26, die neben dem Zwischenkreis im Gehäuse 2 Platz finden. Die Anschlussstecker 22 der DCB-Elemente 20 sowie die Gleichrichteranschlüsse 26 sind elektrisch leitend verbunden mit dem als gedruckte Schaltung ausgeführten Deckel 8, der gleichzeitig das Gehäuse 2 verschließt. Um den in der gedruckten Schaltung fließenden hohen Strömen möglichst wenig Leitungswiderstand entgegenzusetzen, weisen die vorzugsweise aus Kupfer bestehenden Leitungen im Deckel 8 eine Dicke von mindestens 400 µm auf. An einer des Deckels 8 befindet sich eine Steckerleiste 14 mit daraus herausragenden Leistungsanschlüssen 16. Diese Leistungsanschlüsse 16 haben einen Leitungsquerschnitt, der für große Ströme ausreichend zu bemessen ist, um auch hier einen möglichst geringen Leistungswiderstand zu erhalten.

Schließlich befindet sich auf dem Deckel 8 eine als flache rechteckige Scheibe dargestellte Steuerschaltung 10, die über einen nach oben ragenden Verbindungsstecker 12 mit einer Fahrzeugelektronik verbunden werden kann.

Anstelle des skizzierten Aufbaus mit DCB-Elementen 20 kann die gleiche Funktion ebenso mittels eines diskreten Schaltungsaufbaus aus Halbleiterbauelementen und diese mit den übrigen Bauteilen verbindende Kupferleitungen erfolgen. Ebenso können die Leistungstransistoren mit einer auf der Bodenfläche 4c des Gehäuses 2 angebrachten gedruckten Schaltung verbunden sein, die in diesem Fall vorzugsweise mit Kupferbahnen von mehr als 400 µm Dicke versehen ist. Bei einem Aufbau mit einzelnen Transistoren kann es auch vorteilhaft sein, diese so zu montieren, wie dies in Figur 3 angedeutet ist. Hierbei sind diskrete Transistoren 21 an einen Kühlkörper 36 montiert und werden über Federn 34 an ihrem Platz gehalten. Zwischen stufenartig gestaltetem Kühlkörper 36 und Bodenfläche 4c des Gehäuses ist ein Hohlraum gebildet, der als Kühlkanal 7 fungiert und in dem Kühlflüssigkeit zirkulieren kann.

Die aus dem Gehäuse 2 herausgeführten Anschlussstutzen 6 sind mit den Kühlkanälen 7 im Gehäuse verbunden und dienen zur Anbindung des Gehäuses 2 an einen Kühlkreislauf. Dies kann bspw. der bereits vorhandene Kühlkreislauf einer wassergekühlten Brennkraftmaschine eines Kraftfahrzeuges sein. Falls im oder am Gehäuse ein zusätzlicher Temperatursensor vorhanden ist, kann dessen Ausgangssignal zur Feinsteuerung des Kühlkreislaufes im Gehäuse 2 dienen, bspw. indem die Durchflussgeschwindigkeit und/oder der Volumenstrom der zu- und abgeführten Kühlflüssigkeit reguliert wird.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

## Patentansprüche

1. Gehäuse mit Flüssigkeitskühlung, das umfasst:
- ein Gehäuse (2) mit einem Deckel (8), die einen Raum bilden, der zur Aufnahme von elektrischen und/ oder elektronischen Komponenten und Bauteilen (20, 21, 24, 30) dient,
- in das Gehäuse (2) eingebrachte Kühlkanäle (7), die mit Kühlflüssigkeit gefüllt sind,
- wobei die im Gehäuse (2) befindlichen Kühlkanäle (7) integraler Bestandteil des Gehäuses (2) sind,
- wobei die Bauteile (20, 21, 24, 30), thermisch leitend an einer Gehäusewand (4a, 4b, 4c) und /oder am Deckel (8) montiert sind, und
**dadurch gekennzeichnet, dass**
- der Deckel (8) des Gehäuses (2) als Leiterplatte zur elektrischen Kontaktierung der im Gehäuse (2) befindlichen Komponenten und Bauteile (20, 21, 24, 30) ausgebildet ist.

2. Gehäuse nach Anspruch 1, **dadurch gekennzeichnet, dass** im Gehäuse (2) eine Vielzahl von abschnittsweise parallelen Kühlkanälen (7) vorgesehen sind.

3. Gehäuse nach Anspruch 2, **dadurch gekennzeichnet, dass** sich die Kühlkanäle (7) über alle Seiten (4a, 4b, 4c) des Gehäuses (2) erstrecken.

4. Gehäuse nach einem der vorstehenden Ansprüche, **dadurch gekennzeichnet, dass** das Gehäuse (2) aus spritzgegossenem Leichtmetall besteht.

5. Gehäuse nach einem der vorstehenden Ansprüche, **dadurch gekennzeichnet, dass** an den inneren Seitenwänden des Ge häuses (2) jeweils DCB(Direct Copper Bounding)-Elemente (20) thermisch leitend befestigt sind.

6. Gehäuse nach Anspruch 1, **dadurch gekennzeichnet, dass** auf dem als Leiterplatte ausgebildeten Deckel (8) Kupferbahnen von ca. 400 µm Dicke aufgebracht sind.

7. Gehäuse nach einem der vorstehenden Ansprüche, **gekennzeichnet durch** einen weitgehend symmetrischen Aufbau ei nes im Gehäuse (2) befindlichen Leistungsumrichters.

8. Gehäuse nach Anspruch 7, **gekennzeichnet durch** einen symmetrischen Aufbau eines Zwischenkreises des LeistungsUmrichters.

9. Gehäuse nach Anspruch 7 oder 8, **gekennzeichnet durch** minimale Leitungswege zwischen den Komponenten (20, 21, 24, 30) des symmetrisch aufgebauten Leistungs-Umrichter.

10. Gehäuse nach einem der vorstehenden Ansprüche, **dadurch gekennzeichnet, dass** das Gehäuse (2) zur Aufnahme von Steuerungskomponenten (10, 20, 21, 24, 30) eines integrierten Starter-Generators in einem Kraftfahrzeug vorgesehen ist, und dass die im Gehäuse (2) befindlichen Kühlkanäle (7) mit einem Kühlkreislauf einer Brennkraft maschine gekoppelt sind.

## Claims

1. Housing with liquid cooling, comprising:
- a housing (2) with a cover (8) which together form a space serving to accommodate electrical and/or electronic components and parts (20, 21, 24, 30),
- cooling channels (7) introduced into the housing (2) which are filled with cooling liquid,
- the cooling channels (7) contained in the housing (2) being an integral part of the housing (2),
- the components (20, 21, 24, 30) being mounted on a wall (4a, 4b, 4c) of the housing and/or on the cover (8) so as to be thermally conducting, and
**characterised in that**
- the cover (8) of the housing (2) is embodied as a printed circuit board for electrical contacting of the components and parts (20, 21, 24, 30) contained in the housing (2).

2. Housing according to claim 1, **characterised in that** a plurality of cooling channels (7) arranged in parallel in sections are provided.

3. Housing according to claim 2, **characterised in that** the cooling channels (7) extend over all sides (4a, 4b, 4c) of the housing (2).

4. Housing according to one of the preceding claims, **characterised in that** the housing (2) is made of die-cast light metal.

5. Housing according to one of the preceding claims, **characterised in that** DCB (Direct Copper Bonding) elements (20) are fixed to each of the inner side walls of the housing (2) so as to be thermally conducting.

6. Housing according to claim 1, **characterised in that** copper tracks approximately 400 µm thick are mounted on the cover (8) which is embodied as a printed circuit board.

7. Housing according to one of the preceding claims, **characterised by** a largely symmetrical arrangement of a power converter contained in the housing (2).

8. Housing according to claim 7, **characterised by** a symmetrical arrangement of an intermediate circuit of the power converter.

9. Housing according to claim 7 or 8, **characterised by** minimum conduction paths between the components (20, 21, 24, 30) of the symmetrically arranged power converter.

10. Housing according to one of the preceding claims, **characterised in that** the housing (2) is provided for accommodating control components (10, 20, 21, 24, 30) of an integrated starter-generator in a motor vehicle, and **in that** the cooling channels (7) contained in the housing (2) are coupled to a cooling circuit of an internal combustion engine.

## Revendications

1. Boîtier avec refroidissement par liquide qui comprend :
- un boîtier (2) avec un couvercle (8) qui forment un volume qui sert à loger des composants et des éléments de construction électriques et/ou électroniques (20, 21, 24, 30),
- des conduits de refroidissement (7) montés dans le boîtier (2) qui sont remplis avec un liquide de refroidissement,
dans lequel
- les conduits de refroidissement (7) se trouvant dans le boîtier (2) font partie intégrante du boîtier (2),
dans lequel
- les éléments de construction (20, 21, 24, 30) sont montés de manière thermiquement conductrice à une paroi (4a, 4b, 4c) du boîtier et/ou au couvercle (8), et
**caractérisé en ce que**
- le couvercle (8) du boîtier (2) est conçu comme une carte de circuits imprimés pour la mise en contact électrique des composants et des éléments de construction (20, 21, 24, 30) se trouvant dans le boîtier (2).

2. Boîtier selon la revendication 1, **caractérisé en ce qu'**il est prévu dans le boîtier (2) une pluralité de conduits de refroidissement (7) parallèles par segments.

3. Boîtier selon la revendication 2, **caractérisé en ce que** les conduits de refroidissement (7) s'étendent sur tous les côtés (4a, 4b, 4c) du boîtier (2).

4. Boîtier selon l'une quelconque des revendications précédentes, **caractérisé en ce que** le boîtier (2) est constitué de métal léger moulé par injection.

5. Boîtier selon l'une quelconque des revendications précédentes, **caractérisé en ce que** des éléments DCB (Direct Copper Bounding) 20 sont fixés de manière thermiquement conductrice aux parois latérales intérieures du boîtier (2).

6. Boîtier selon la revendication 1, **caractérisé en ce que** des bandes de cuivre ayant une épaisseur d'environ 400 µm sont appliquées sur le couvercle (8) conçu comme une carte de circuits imprimés.

7. Boîtier selon l'une quelconque des revendications précédentes, **caractérisé par** une construction sensiblement symétrique d'un convertisseur de puissance se trouvant dans le boîtier (2).

8. Boîtier selon la revendication 7, **caractérisé par** une construction symétrique d'un circuit intermédiaire du convertisseur de puissance.

9. Boîtier selon la revendication 7 ou 8, **caractérisé par** des distances de lignes minimales entre les composants (20, 21, 24, 30) du convertisseur de puissance de construction symétrique.

10. Boîtier selon l'une quelconque des revendications précédentes, **caractérisé en ce que** le boîtier (2) est prévu pour le logement de composants de commande (10, 20, 21, 24, 30) d'un générateur de starter intégré dans un véhicule automobile et **en ce que** les conduits de refroidissement (7) se trouvant dans le boîtier (2) sont raccordés à un circuit de refroidissement d'un moteur à combustion interne.
